Europäisches Patentamt

European Patent Office

Office européen des brevets

(11) Publication number: **0 103 410**
**B1**

(12) EUROPEAN PATENT SPECIFICATION

(45) Date of publication of patent specification: **02.11.89**

(21) Application number: **83304669.1**

(22) Date of filing: **12.08.83**

(51) Int. Cl.⁴: **H 03 F 3/00, H 03 H 19/00**

(54) Switched-capacitor stage with differential output.

(30) Priority: **18.08.82 CA 409631**

(43) Date of publication of application:
**21.03.84 Bulletin 84/12**

(45) Publication of the grant of the patent:
**02.11.89 Bulletin 89/44**

(84) Designated Contracting States:
**DE FR GB NL SE**

(56) References cited:
**DE-A-2 950 433**

**IEE 5TH EUROPEAN SOLID STATE CIRCUITS
CONFERENCE - ESSCIRC 79, 18th-21st
September 1979, pages 131-133,
Southampton, GB; R. DESSOULAVY et al.: "A
synchronous bandpass switched capacitor
filter"**

(73) Proprietor: **NORTHERN TELECOM LIMITED
1600 Dorchester Boulevard West
Montreal Quebec H3H 1R1 (CA)**

(72) Inventor: **Bennett, Jeffrey Henry
2612 Severn Avenue
Ottawa Ontario, K2B 7V7 (CA)**

(74) Representative: **Crawford, Andrew Birkby et al
A.A. THORNTON & CO. Northumberland House
303-306 High Holborn
London WC1V 7LE (GB)**

Courier Press, Leamington Spa, England.

# Description

This invention relates to a switched-capacitor stage for producing differential output signals from a single-ended input signal.

Switched capacitor stages are already known. One form of switched capacitor stage is disclosed in DE—A—2950433 where two switched capacitors are disposed between a single-ended input and a single-ended output. Each capacitor is switched between the same two conditions but out of phase with each other.

It is also generally known to produce differential output signals from a single-ended input signal using two buffer amplifiers, one using two similar buffer amplifiers with an inverting amplifier connected from the input and output of one of them to the input of the other. These arrangements have the disadvantage of having different output characteristics for the different buffers and/or different signal delays through the different signal paths.

Accordingly, an object of this invention is to provide a new arrangement for producing different output signals from a single-ended input signal using switched-capacitor techniques. Such an arrangement is particularly useful where preceding circuitry also uses switched-capacitor techniques, but the invention is not limited in this respect.

According to the present invention there is provided a switched capacitor stage having a single-ended input and first and second differential outputs, the stage comprising first switching means connected to the input, a first capacitor coupled between one of the differential outputs and the first switching means, a second capacitor coupled between the other of the differential outputs and the first switching means, a second switching means coupled between said one differential output and the first capacitor, and a third switching means coupled between said other differential output and the second capacitor, the first, second and third switching means being operable between first and second conditions, in the first of which one of the capacitors is coupled between the input and its respective output while the other capacitor is coupled between the input and a reference or earth potential, and in the second of which said one capacitor has both its plates coupled simultaneously to a reference or earth potential while the said other capacitor has one plate coupled to a reference or earth potential and its other plate connected to its respective output.

Preferably the stage includes first and second amplifiers via which the first and second capacitors respectively are coupled to the first and second output terminals respectively, two unswitched capacitors each coupled between an output and an inverting input of a respective one of the amplifiers, and first and second switched negative feedback capacitors coupled to the first and second amplifiers respectively.

Thus the invention uses a through-switched capacitor and a diagonally-switched capacitor in respective signal paths to provide differential outputs from a single-ended input. As explained below, the arrangement also effects an interpolation of the differential output signal, which is advantageous.

The invention will be further understood from the following description with reference to the accompanying drawings, in which:

Figure 1 schematically illustrates a switched-capacitor stage according to a preferred embodiment of the invention; and

Figure 2 is a signal diagram illustrating the interpolating effect of the stage.

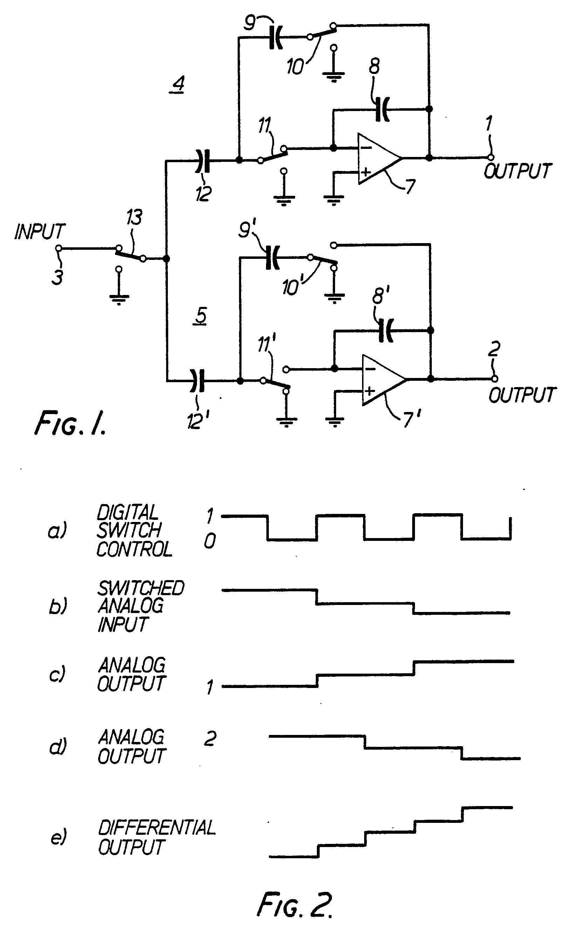

As used herein, the term "unswitched capacitor" means a capacitor that is permanently connected in the circuit, or connected to a reference potential, during one of two switching states; and the term "diagonally-switched capacitor" means a switched-capacitor whose terminals are alternately grounded during successive ones of two switching states. In Figure 1 the various switches of the switched capacitors are shown in one of their two switching states; all of the switches are operated in synchronism by means not shown. The switches are controlled and are implemented by CMOS devices as is well known in the art.

Referring to Figure 1, the switched-capacitor stage produces differential output signals at output terminals 1 and 2 from a single-ended input signal at an input 3. To this end the stage provides two signal paths 4 and 5 from the input 3 to the output terminals 1 and 2 respectively. Except for the timing of the switch operations, the two signal paths are identical. Each signal path includes a differential amplifier 7,7′, having an output connected to the respective output terminal 1 or 2, a non-inverting input connected to circuit ground, and an inverting input; an unswitched integrating capacitor 8,8′ connected between the inverting input and the output of the amplifier; a through-switched negative feedback capacitor 9,9′ connected via a switch 10,10′ to the output of the amplifier and via a switch 11 to the inverting input of the amplifier; a further switched-capacitor 12,12′ having one terminal connected to the junction between the capacitor 9,9′ and the switch 11,11′, and hence connected to the inverting input of the amplifier via the switch 11,11′, and a further switch 13 connecting the other terminal of the capacitor 12 to the input 3. A single switch 13 serves commonly for the two signal paths 4 and 5, but separate switches could be provided if desired.

The switches 10,10′, 11,11′ and 13 are all operated in synchronism with one another, for example at a switching frequency of 125 kHz for handling voice-frequency signals at frequencies up to 3.5 kHz. As illustrated in Figure 1, the switches 10 and 11 in the signal path 5 are operated with the opposite phase to the switch 13 and to the switches 10 and 11 in the signal path 4. In consequence, in the signal path 4 the capacitor 9 is through-switched via the switches 10 and 11 and the capacitor 12 is through-switched via the switches 13 and 11, whereas in the signal path 5 the capacitor 9' is through-switched via the switches 10' and 11' but the capacitor 12' is diagonally-switched via the switches 13 and 11'.

As a result of the diagonal switching of the capacitor 12' in the signal path 5, and the phasing of the switches 10' and 11' in this signal path in relation to the switch 13, the input signal is applied to the inverting input of the amplifier 7' in the signal path 5 inverted and delayed by half of one period of the switching frequency. The inversion results in the production of the differential output signals at the output terminals 1 and 2. The delay is advantageous in providing an interpolation effect as described below with reference to Figure 2.

Figure 2 illustrates signals which may occur during three cycles of a digital switch control waveform shown at Figure 2(a), the switches 10,10', 11,11' and 13 in Figure 1 being in the states shown in Figure 1 when the digital switch control waveform is a logic 1 level. Figure 2(b) shows a switched analog input signal which is assumed to be applied to the input 3 from preceding switched-capacitor circuitry. This input as shown in Figure 2(b) is of decreasing magnitude, each magnitude level remaining constant for the duration of one period of the switch control waveform. The resultant switched analog outputs at the terminals 1 and 2 are shown in Figures 2(c) and 2(d) respectively, the output at the terminal 2 being inverted and delayed by half a period in relation to that at the terminal 1 due to the diagonally-switched capacitor 12 in the signal path 5, and the related switching state timing. The resultant differential output signal, shown in Figure 2(e), has steps occurring at twice the switch control frequency at a relative magnitude only half that of the input and individual output signals. This interpolation effect, providing doubled step frequency and halved relative step magnitude, considerably facilitates filtering and smoothing of the differential output signal.

As will be appreciated by those skilled in the art, the switched-capacitor stage illustrated in Figure 1 can be implemented, together with other switched-capacitor circuitry if desired, in a single integrated circuit, for example using a CMOS double polysilicon process. In such an arrangement each of the capacitors may, for example, have a nominal capacitance of 2pF, the bottom plate of each capacitor being represented by a curved line in Figure 1. In order to facilitate use of such an arrangement in, for example, a telephone repeater for voice frequency channels, each output of the stage in Figure 1 may be additionally provided with a power buffer stage and an output protection device of known form.

The invention is not limited to the particular embodiment described, and numerous modifications, variations, and adaptations may be made thereto without departing from the scope of the invention as defined in the claims.

## Claims

1. A switched capacitor stage having a single-ended input (3) and first and second differential outputs (1, 2), the stage comprising first switching means (13) connected to the input (3), a first capacitor (12) coupled between one of the differential outputs (1) and the first switching means (13), a second capacitor (12') coupled between the other of the differential outputs (2) and the first switching means (13), a second switching means (11) coupled between said one differential output (1) and the first capacitor (12), and a third switching means (11') coupled between said other differential output and the second capacitor (12'), the first, second and third switching means being operable between first and second conditions, in the first of which one of the capacitors (12) is coupled between the input (3) and its respective output (1) while the other capacitor (12') is coupled between the input (3) and a reference or earth potential, and in the second of which said one capacitor (12) has both its plates coupled simultaneously to a reference or earth potential while the said other capacitor (12') has one plate coupled to a reference or earth potential and its other plate connected to its respective output (2).

2. A switched-capacitor stage as claimed in claim 1, wherein the first capacitor (12) and the second switching means (11) are located in a first signal path (4) and the second capacitor (12') and the third switching means (11') are located in a second signal path (5), each signal path comprising an amplifier (7,7') having an inverting input and an output coupled to the respective output terminal, an unswitched capacitor (8,8') coupled between the inverting input and the output of the amplifier (7,7') a feedback capacitor (9,9') and further switching means (10) operating in synchronism with the second and third switching means (11,11') for selectively and simultaneously connecting the terminals of the feedback capacitor (9,9') either to the output (1, 2) and inverting input respectively of the amplifier or to a reference or earth potential.

3. A switched-capacitor stage as claimed in claim 2 wherein the first switching means (13) of the two signal paths (4, 5) is constituted by a single switching means common to the two signal paths.

## Patentansprüche

1. Geschaltete Kondensatorstufe mit einem einendigen Eingang (3) und ersten und zweiten Differentialausgängen (1, 2), wobei die Stufe erstes, an dem Eingang (3) angeschlossenes Schaltermittel (13), einen zwischen einem der Differentialausgänge (1) und dem ersten Schaltermittel (13) gekoppelten ersten Kondensator, einen zwischen dem anderen Differentialausgang (2) und dem ersten Schaltermittel (13) gekoppelten zweiten Kondensator (12'), ein zwischen dem einen Differentialausgang (1) und dem ersten Kondensator (12) gekoppeltes zweites Schaltermittel (11) und ein zwischen dem anderen Differentialausgang und dem zweiten Kondensator (12') gekoppeltes drittes Schaltermittel (11') umfaßt, das erste, das zweite und das dritte Schaltermittel zwischen ersten und zweiten Zuständen betätigbar sind, wovon in dem ersten Zustand ein Kondensator (12) zwischen dem Eingang (3) und ihrem jeweiligen Ausgang (1) gekoppelt ist, während der andere Kondensator (12') zwischen dem Eingang (3) und einem Referenz- oder Endpotential gekoppelt ist, und in dem zweiten der eine Kondensator (12) seine beiden Beläge gleichzeitig mit einem Referenz- oder Erdpotential gekoppelt hat, während der andere Kondensator (12') einen Belag mit einem Referenz- oder Erdpotential gekoppelt hat und sein anderer Belag mit ihrem jeweiligen Ausgang (2) verbunden ist.

2. Geschaltete Kondensatorstufe nach Anspruch 1, bei der der erste Kondensator (12) und das zweite Schaltermittel (11) in einem ersten Signalweg (4) angeordnet sind, und der zweite Kondensator (12') und das dritte Schaltermittel (11') in einem zweiten Signalweg (9) angeordnet sind, wobei jeder Signalweg einen Verstärker (7, 7') mit einem invertierenden Eingang und einem mit der jeweiligen Ausgangsklemme gekoppelten Ausgang umfaßt, einen zwischen dem invertierenden Eingang und dem Ausgang des Verstärkers (7, 7') gekoppelten ungeschalteten Kondensator (8, 8'), einen Rückkoppel-Kondensator (9, 9') und weitere, synchron mit dem zweiten und dem dritten Schaltermittel (11, 11') arbeitende Schaltermittel (10, 10') umfaßt zum wahlweisen und gleichzeitigen Verbinden der Klemmen des Rückkoppelkondensators (9, 9') entweder mit dem Ausgang (1, 2) und dem invertierenden Eingang des jeweiligen Verstärkers oder mit einem Referenz- oder Erdpotential.

3. Geschaltete Kondensatorstufe nach Anspruch 2, bei der das erste Schaltermittel (13) der beiden Signalwege (4, 5) durch ein den beiden Signalwegen gemeinsames einzelnes Schaltermittel gebildet ist.

**Revendications**

1. Etage à condensateurs commutés ayant une entrée (3) à une seule extrémité et des première et secondes sorties différentielles (1, 2), l'étage comprenant un premier moyen de commutation (13) connecté à l'entrée (3), un premier condensateur (12) monté entre l'une des sorties différentielles (1) et le premier moyen de commutation (13), un second condensateur (12') connecté entre l'autre des sorties différentielles (2) et le premier moyen de commutation (13), un second moyen de commutation (11) placé entre la première sortie différentielle (1) et le premier condensateur (12) et un troisième moyen de commutation (11') monté entre l'autre sortie différentielle et le second condensateur (12'), les premier, second et troisième moyens de commutation pouvant fonctionner entre des première et seconde conditions, dans la première desquelles l'un des condensateurs (12) est monté entre l'entrée (3) et sa sortie respective (1) alors que l'autre condensateur (12') l'est entre l'entrée (3) et un potentiel de référence ou potentiel de masse, et dans la seconde desquelles le premier condensateur (12) a ses deux plaques reliées simultanément à un potentiel de référence ou potentiel de la masse alors que l'autre condensateur (12') a une plaque reliée à un potentiel de référence ou potentiel de la masse et son autre plaque connectée à sa sortie respective (2).

2. Etage à condensateurs commutés selon la revendication 1, dans lequel le premier condensateur (12) et le second moyen de commutation (11) sont situés dans un premier trajet de signal (4) et le second condensateur (12') et le troisième moyen de commutation (11') sont placés dans un second trajet de signal (5), chaque trajet de signal comportant un amplificateur (7, 7') ayant une entrée d'inversion et une sortie reliée à la borne de sortie respective, un condensateur non commuté (8, 8') monté entre l'entrée d'inversion et la sortie de l'amplificateur (7, 7'), un condensateur de réaction (9, 9') et un autre moyen de commutation (10) fonctionnant en synchronisme avec les second et troisième moyens de commutation (11, 11') pour connecter sélectivement et simultanément les bornes du condensateur de réaction (9, 9') soit à la sortie (1, 2) et à l'entrée d'inversion, respectivement, de l'amplificateur, soit à un potentiel de référence ou potentiel de la masse.

3. Etage à condensateurs commutés selon la revendication 2, dans lequel le premier moyen de commutation (13) des deux trajets de signal (4, 5) est constitué d'un seul moyen de commutation commun aux deux trajets de signal.

INPUT

10'

11'

12'

7'

**FIG. 1.**

a) DIGITAL SWITCH CONTROL — 1 0

b) SWITCHED ANALOG INPUT

c) ANALOG OUTPUT 1

d) ANALOG OUTPUT 2

e) DIFFERENTIAL OUTPUT

**FIG. 2.**

1